# EUROPÄISCHE PATENTSCHRIFT

(11) **EP 2 830 220 B1**
(45) Veröffentlichungstag und Bekanntmachung des Hinweises auf die Patenterteilung: **14.11.2018**
(21) Anmeldenummer: 14176576.8
(22) Anmeldetag: 10.07.2014
(51) Int. Cl.: H03K 17/96

(54) **Bedienteil für eine Bedieneinrichtung und Bedieneinrichtung**
Control unit for an operating device and operating device
Élément de commande pour un dispositif de commande et dispositif de commande

(30) Priorität: 18.07.2013 DE 102013214164
(43) Veröffentlichungstag der Anmeldung: 28.01.2015
(73) Patentinhaber: E.G.O. Elektro-Gerätebau GmbH, 75038 Oberderdingen (DE)
(72) Erfinder: Volk, Martin, 75038 Oberderdingen (DE)
(74) Vertreter: Patentanwälte Ruff, Wilhelm, Beier, Dauster & Partner mbB

(56) Entgegenhaltungen:
- EP-A1- 2 141 810
- EP-A1- 2 564 751
- WO-A1-2013/041520
- DE-A1-102011 006 021
- DE-A1-102011 077 899
- US-A1- 2007 144 874
- US-A1- 2012 161 795

## Beschreibung

### Anwendungsgebiet und Stand der Technik

Die Erfindung betrifft ein Bedienteil für eine Bedieneinrichtung, wie sie insbesondere für ein Elektrogerät verwendet werden kann, sowie eine Bedieneinrichtung mit einem solchen Bedienteil.
Eine ähnliche Bedieneinrichtung samt Bedienteil ist aus der DE 102011006021 A1 bekannt. Ein Bedienteilgehäuse weist eine Vielzahl von Anzeigeelementen auf, die jeweils einen Lichtleitkanal für eine Leuchtanzeige aufweisen. Das Bedienteilgehäuse ist gitterartig bzw. in einem Raster ausgebildet, und auf der Oberseite von Gitterstegen verlaufen in einzelne Teil-Bereiche aufgeteilte Teil-Sensorelemente, die aus einem dünnen Metallblech bestehen. Das Auflegen eines Fingers auf die Oberseite einer Bedienfläche über einem dieser jeweiligen Teil-Sensorelemente kann erkannt werden, so dass eine örtlich aufgelöste Bedienung erfolgen kann mit einer diesem Bedienort zugeordneten
Eine weitere ähnliche Bedieneinrichtung samt Bedienteil ist aus der DE102011077899 A1 bekannt.

### Aufgabe und Lösung

Der Erfindung liegt die Aufgabe zugrunde, ein eingangs genanntes Bedienteil sowie eine damit versehene Bedieneinrichtung zu schaffen, mit denen Probleme des Standes der Technik vermieden werden können und es insbesondere möglich ist, eine praxistaugliche und montagefreundliche Bedieneinrichtung zu schaffen, die eine vielfältige und anwenderfreundliche Leuchtanzeige sowie eine komfortable und intuitive Bedienung ermöglicht.
Gelöst wird diese Aufgabe durch ein Bedienteil mit den Merkmalen des Anspruchs 1 sowie durch eine Bedieneinrichtung mit den Merkmalen des Anspruchs 12 Vorteilhafte sowie bevorzugte Ausgestaltungen der Erfindung sind Gegenstand der weiteren Ansprüche und werden im Folgenden näher erläutert. Dabei werden manche der Merkmale nur für das Bedienteil oder nur für die Bedieneinrichtung beschrieben. Sie sollen jedoch unabhängig davon sowohl für das Bedienteil als auch für die Bedieneinrichtung selbstständig gelten können. Der Wortlaut der Ansprüche wird durch ausdrückliche Bezugnahme zum Inhalt der Beschreibung gemacht.
Es ist vorgesehen, dass das Bedienteil ein Bedienteilgehäuse und mehrere Lichtleitkanäle für Leuchtanzeigen bzw. zur Leuchtanzeige aufweist, also mindestens zwei Lichtleitkanäle. Die Lichtleitkanäle sind benachbart zueinander angeordnet, und dabei durch Trennwände des Bedienteilgehäuses voneinander getrennt. Diese Trennwände sind Teil des Bedienteilgehäuses und lichtundurchlässig, vorteilhaft bestehen sie aus Kunststoff. Das Bedienteil bzw. das Bedienteilgehäuse weist zumindest an einer Oberseite der Lichtleitkanäle bzw. an einer Oberseite des Bedienteilgehäuses lichtdurchlässiges Lichtleitermaterial auf. Dies kann einerseits übliches Lichtleitermaterial sein, welches weitgehend lichtdurchlässig ist, beispielsweise mit 90% oder sogar mehr als 95% Transmission. Alternativ kann es auch ein transluzentes Lichtleitermaterial sein, welches das hindurchgestrahlte Licht gleichmäßiger macht für eine gleichmäßige Leuchtanzeige, also eine Art Diffusor. Als Leuchtmittel bzw. Lichtquellen können beispielsweise unterhalb der Lichtleitkanäle bzw. an deren unterem Endbereich LED angeordnet sein.

Erfindungsgemäß werden an einem oberen Bereich bzw. an einer Oberseite des Bedienteils kapazitive Sensorelemente vorgesehen Diese kapazitiven Sensorelemente können ein Auflegen eines Fingers als Bedienung erkennen oder das Darüberziehen eines aufgelegten Fingers. Das entsprechende grundsätzliche Funktionsprinzip ist aus der vorgenannten DE 102011006021 A1 bekannt.
Erfindungsgemäß ist das Lichtleitermaterial so ausgebildet bzw. so am Bedienteil oder am Bedienteilgehäuse vorgesehen, dass es über mindestens zwei benachbarten Lichtleitkanälen vorgesehen ist und durchgehend über diesen verläuft, vorteilhaft als eine Art Brücke. Es bildet also zumindest eine durchgehende Schicht über diesen zwei Lichtleitkanälen. Vorteilhaft verläuft das Lichtleitermaterial bzw. dessen Schicht durchgehend über eine Trennwand zwischen zwei Lichtleitkanälen, beispielsweise als vorgenannte Brücke, besonders vorteilhaft über noch mehr Lichtleitkanäle bzw. alle Lichtleitkanäle.
Mit der Erfindung ist es möglich, dass Leuchtanzeigen nicht nur maximal in der Größe der Lichtleitkanäle selbst zu sehen sind bzw. leuchten können. Vielmehr ergibt sich bei Aktivieren von Leuchtmitteln zweier benachbarter Lichtleitkanäle die Möglichkeit, deren gesamte Fläche samt Zwischenfläche zu beleuchten bzw. dies ist zumindest grundsätzlich möglich. So können, wie nachfolgend noch erläutert wird, spezielle Symbole durchgehend über beide Lichtleitkanäle hinweg durch Beleuchtung angezeigt bzw. dargestellt werden. Somit können besonders große Symbole dargestellt werden. Für eine bereichsweise unterschiedliche mögliche Bedienung können die voneinander getrennten und jedem Einzelbereich bzw. jedem Lichtleitkanal zugeordneten kapazitiven Sensorelemente vorgesehen sein. Des Weiteren ist es möglich, insbesondere wenn mehrere Lichtleitkanäle in einer Reihe angeordnet sind und über allen diesen durchgehendes Lichtleitermaterial vorgesehen ist, einen durchgehend beleuchteten Streifen als Leuchtanzeige sichtbar zu machen in einem Betriebsmodus. In einem anderen Betriebsmodus können wiederum nur einzelne Lichtleitkanäle beleuchtet werden bzw. können unbeleuchtete Lichtleitkanäle vorgesehen werden, so dass wieder mehr der Zustand von beleuchteten einzelnen Feldern entsteht.

In vorteilhafter Ausgestaltung der Erfindung sind die meisten Trennwände gleich hoch, vorzugsweise alle. Auch die Lichtleitkanäle dazwischen sind vorteilhaft gleich hoch. Besonders vorteilhaft sind lichtundurchlässige Trennwände nicht nur zwischen zwei Lichtleitkanälen vorgesehen, sondern auch an den Außenseiten der Lichtleitkanäle bzw. des Bedienteilgehäuses.

Durch die Trennwände kann allgemein ein starkes Übersprechen bzw. Überleuchten zwischen benachbarten Lichtleitkanälen vermieden werden. Dieses findet sozusagen dann nur noch lokal begrenzt und nach Art einer geringen Größenerweiterung des beleuchteten Bereichs oberhalb des Lichtleitkanals als Leuchtanzeige statt, wobei dieser Lichtleitkanal dadurch beispielsweise zwischen 10% und 30% oder sogar 40% seitlich vergrößert wird.

In weiterer Ausgestaltung der Erfindung kann die Höhe bzw. Dicke des Lichtleitermaterials über den Trennwänden, die also über die Trennwände hinweg verläuft und zwei Bereiche über benachbarten Leuchtanzeigen bzw. Lichtleitkanälen verbindet, zwischen 5% und 30% der Höhe der Lichtleitkanäle liegen. Je geringer diese Höhe bzw. Dicke, desto geringer ist die seitliche Ausdehnung der Beleuchtung des Lichtleitermaterials durch diesen Lichtleitkanal bzw. durch dessen Leuchtmittel. Als alternative Definition kann die Höhe bzw. Dicke des Lichtleitermaterials mindestens 50% und bis zu 150% oder 200% des Abstands zweier Lichtleitkanäle zueinander betragen. Auch so kann zuverlässig ein seitliches Überleuchten oberhalb der Trennwände erreicht werden.

Vorteilhaft ist eine Oberseite des Lichtleitermaterials eben um eine Form der Oberseite des gesamten Bedienteils zu beeinflussen kann bzw. zu bestimmen. Diese Oberseite sollte vorteilhaft parallel zu einer Ebene sein, an der die Oberkanten der Trennwände anliegen, besonders vorteilhaft auch parallel zu einer Unterseite des Bedienteilgehäuses. Losgelöst davon sollte das Lichtleitermaterial oberhalb der Trennwände eine überall gleiche Höhe bzw. Dicke aufweisen.

Die Lichtleitkanäle können von oben her weitgehend, insbesondere von 50% bis zu 95%, eventuell auch mehr, mit Lichtleitermaterial gefüllt sein. So kann im unteren Bereich Platz für ein Leuchtmittel frei bleiben, das in den Lichtleitkanal hineinleuchtet bzw. hineinragt und geringen Abstand zu dem Lichtleitermaterial darin aufweist. Besonders vorteilhaft füllt dasselbe Lichtleitermaterial einerseits die Lichtleitkanäle und verläuft andererseits oberhalb der Trennwände über diese hinweg. Somit ist das Lichtleitermaterial einteilig, einstückig und in einem Schritt gefertigt, insbesondere als Mehrkomponenten-Kunststoffspritzgießen zusammen mit mindestens den Trennwänden.

In vorteilhafter Ausgestaltung der Erfindung kann auf der Oberseite des Lichtleitermaterials bzw. oberhalb der Lichtleitkanäle eine Abdeckung oder Maskierung vorgesehen sein. Diese kann beispielsweise eine Beschichtung mit einem Lack oder lackähnlichem Beschichtungsmaterial sein. Dies ist grundsätzlich schon bekannt, siehe beispielsweise die DE 102009036161 A1. Diese Abdeckung kann Öffnungen bzw. Durchlässe in Zeichen- oder Symbolform aufweisen, welche die für einen Bediener sichtbare Leuchtanzeige definieren bzw. bestimmen. Dazu können für die Leuchtanzeigen Öffnungen bzw. Durchlässe in Zeichen- bzw. Symbolform vorgesehen sein. Die Abdeckung selbst ist also lichtundurchlässig und eine Öffnung darin wird in gewünschter Form durchleuchtet. Alternativ zu einer lackähnlichen Beschichtung, die beispielsweise aufgesprüht, aufgedruckt oder durch Tauchen odgl. aufgebracht werden kann, kann auch eine weitere Kunststoff-Schicht vorgesehen sein, die an das Bedienteilgehäuse in einem vorgenannten Mehrkomponenten-Kunststoffspritzgießen angebracht wird.

Die vorgenannten Öffnungen bzw. Durchlässe oder Ausnehmungen in der Abdeckung können bei einer Ausgestaltung der Erfindung bereits bei Aufbringen der Abdeckung vorgesehen werden. Alternativ kann die Abdeckung großflächig bzw. vollflächig aufgebracht werden, wobei dann die Öffnung bzw. ein Durchlass materialabtragend hergestellt wird, beispielsweise mittels eines Lasers. Hierzu wird auf die vorgenannte DE 102009036161 A1 verwiesen. So können Bedienteile einer einzigen gemeinsamen Bauart auf Kundenwunsch oder für Kleinserien leicht individuell gestaltet werden.

Ein von der Leuchtanzeige angezeigtes und von der Abdeckung frei gelassenes zusammenhängendes bzw. zusammengehörendes Symbol kann also über mindestens zwei benachbarte Lichtleitkanäle verlaufen. Dadurch und mit einer angepassten Steuerung kann eine Bedieneinrichtung bei jeweils identischem Aufbau der einzelnen Lichtleitkanäle und entsprechender Unterteilung derselben eine Anzahl kleiner Symbole dargestellt werden, aber auch mindestens ein größeres Symbol. Das Symbol kann auch so ausgebildet sein, dass es zum einen teilweise und zum anderen ganz dargestellt werden kann für unterschiedliche, aufeinander aufbauende oder sich ergänzende Leuchtanzeigen.

Vorteilhaft weist das Bedienteil mehrere Lichtleitkanäle in einer Reihe auf. Dies können zwei bis zehn oder zwanzig Lichtleitkanäle sein, je nach Anwendungsfall. Diese Reihe kann besonders vorteilhaft gerade sein bzw. in gerader Richtung verlaufen. Damit kann beispielsweise ein länglicher sogenannter Slider als Bedieneinrichtung geschaffen werden, in den Bedienfunktionen integriert sind, wie es grundsätzlich aus der DE 102004044355 A1 bekannt ist.
Des Weiteren können auch mehrere Reihen solcher Lichtleitkanäle nebeneinander vorgesehen sein. Dadurch ergibt sich nicht nur ein sogenannter Slider entlang einer Richtung, sondern ein zweidimensional aufgespanntes Bedienfeld, wie es aus der DE 102009039937 A1 grundsätzlich bekannt ist. Mit der Erfindung kann dieses Bedienfeld auch noch in vielfältiger Art und Weise beleuchtbar sein oder beleuchtete Symbole anzeigen.
Einerseits ist die Ausgestaltung der Lichtleitkanäle relativ frei wählbar. Andererseits wird es als vorteilhaft angesehen, wenn sie in ein gemeinsames Größenraster passen. Dazu können sie entweder jeweils genau eine Größe aufweisen oder ein ganzzahliges Vielfaches dieser Größe als zusammengesetzte Form aufweisen. Dies ist in ähnlicher Form bereits aus der eingangs genannten DE 102011006021 A1 bekannt. Größere Lichtleitkanäle können dann vorteilhaft mehr oder stärkere Leuchtmittel aufweisen als die kleineren.
In vorteilhafter Ausgestaltung der Erfindung ist pro Lichtleitkanal ein kapazitives Sensorelement vorgesehen, insbesondere genau ein einziges kapazitives Sensorelement. Damit kann vorteilhaft das Auflegen eines Fingers auf einen Bereich oberhalb des Lichtleitkanals, vorzugsweise in etwa in dessen Mittelbereich, erkannt werden als gewünschte Bedienung mit einer durch Leuchtanzeige darstellbaren Bedienfunktion. Diese Bedienfunktion kann durch ein beleuchtetes Symbol deutlich angezeigt werden.
Die kapazitiven Sensorelemente benachbarter Lichtleitkanäle sollten getrennt sein voneinander. So ist eine feine räumliche Auflösung der Bedienung möglich.

Die kapazitiven Elemente sind lange und schmale Sensorelemente bzw. Teil-Sensorelemente aus elektrisch leitfähigem Sensormaterial, wie sie beispielsweise aus der DE 102012010321 A1 hervorgehen. Diese können als Rippe oder Erhebung oben auf die Oberseite einer Trennwand aufgebracht sein und seitlich am Bedienteilgehäuse nach unten bis an eine Unterseite gezogen sein zur vorbeschriebenen elektrischen Kontaktierung mittels eines Kontaktfeldes auf einer Leiterplatte. Ihre Breite kann allgemein relativ gering sein mit 0,3 mm bis 1 mm oder 2 mm. Derartige Teil-Sensorelemente sollten einen Lichtleitkanal an zumindest zwei Seiten umgeben bzw. begrenzen und dabei nahezu so lang sein wie diese Seiten. Dies können aneinander anstoßende Seiten sein, so dass die Teil-Sensorelemente winklig zueinander stehen. Dann braucht zwischen zwei Lichtleitkanälen eigentlich immer nur ein Teil-Sensorelement vorhanden sein. Alternativ können sie auch parallel zueinander an der Oberseite oder am oberen Bereich der Trennwand verlaufen, und jeweils ein Sensorelement nahe dem ihm zugeordneten Lichtleitkanal und zwei an den gegenüberliegenden Seiten des Lichtleitkanals. Vorteilhaft verlaufen sie dabei unter dem die Trennwand übergreifenden Lichtleitermaterial, so dass sie die Leuchterscheinung nicht negativ beeinträchtigen.
Mit einem vorbeschriebenen Bedienteil kann eine Bedieneinrichtung mit sehr variabler und vielseitiger sowie neuartiger Leuchtanzeige geschaffen werden. Das Bedienteil liegt dabei unter einer Bedienfläche der Bedieneinrichtung, wobei es vorteilhaft an deren Unterseite angelegt ist. Diese Bedienfläche kann eine Abdeckung oder Außenseite der Bedieneinrichtung sein. Bei Integration der Bedieneinrichtung in ein Elektrogerät gemäß der Erfindung, beispielsweise ein Kochfeld mit einer Kochfeldplatte, kann die Kochfeldplatte die Bedienfläche bilden. Vorteilhaft ist die Bedienfläche lichtdurchlässig.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schrägansicht auf ein erfindungsgemäßes Bedienteil mit mehreren Lichtleitkanälen und durchgehendem Lichtleitermaterial darüber,
- Fig. 2: eine vergrößerte Seitenansicht auf das Bedienteil aus Fig. 1,
- Fig. 3: das Bedienteil aus Fig. 1 eingebaut in eine erfindungsgemäße Bedieneinrichtung und
- Fig. 4: eine Draufsicht auf eine Erweiterung des Bedienteils ähnlich Fig. 1 mit zwei Reihen von Lichtleitkanälen.

### Detaillierte Beschreibung der Ausführungsbeispiele

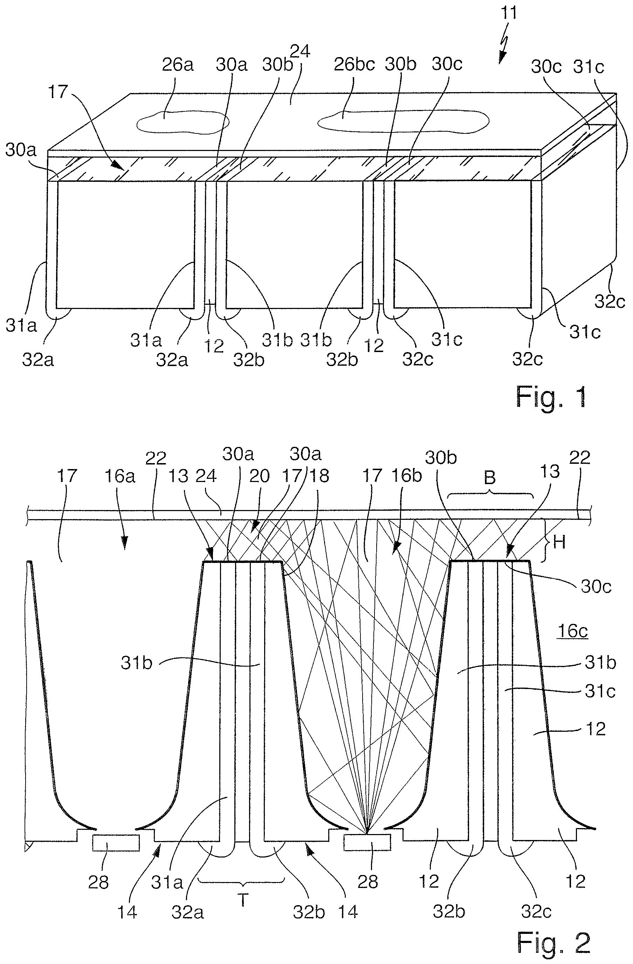

In Fig. 1 ist in schräger Draufsicht ein Bedienteil 11 gemäß einer ersten Ausbildung der Erfindung dargestellt. Es weist ein Bedienteilgehäuse 12 aus lichtundurchlässigem Material bzw. Kunststoff auf, welches eine Oberseite 13 und eine Unterseite 14 aufweist. Dies ist auch aus der vergrößerten Seitenansicht der Fig. 2 zu erkennen.

Im Bedienteil 11 bzw. im Bedienteil 12 sind Lichtleitkanäle 16a bis 16c vorgesehen, und zwar gemäß Fig. 1 entlang einer geraden Reihe, also als einreihiges Bedienteil. Die Lichtleitkanäle 16 sind nach üblicher Art und Weise ausgebildet mit einer sich nach oben bzw. zur Oberseite 13 hin erweiternden Form. Sie sind mit Lichtleitermaterial 17 gefüllt, vorteilhaft einem lichtdurchlässigen Kunststoff wie Polyacryl odgl.. Eventuell kann dieses Lichtleitermaterial 17, zumindest zur Oberseite 13 hin, transluzent sein bzw. Diffusoreigenschaften aufweisen, wie dies an sich bekannt ist. So kann eine Leuchterscheinung bzw. Leuchtanzeige gleichmäßig ausgeleuchtet dargestellt werden. Zur besseren Lichtverteilung kann auf dem Bedienteilgehäuse 12 überall dort, wo Lichtleitermaterial 17 aufgebracht wird, zuvor eine Spiegel-Beschichtung 18 oder eine sonstige, ähnlich wirkende reflektierende Beschichtung vorgesehen sein. Alternativ kann die Oberfläche des Bedienteilgehäuses 12 hier entsprechend glatt bzw. spiegelnd ausgebildet werden.

Zwischen zwei Lichtleitkanälen 16 sind Trennwände T gebildet, und zwar hauptsächlich von dem Bedienteilgehäuse 12 bzw. dessen Material selbst. Die Breite B der Trennwände T am oberen Ende beträgt etwa 30% einer Höhe der Lichtleitkanäle 16 bzw. etwa die Hälfte einer maximalen Breite der Lichtleitkanäle 16. Über den Trennwänden T bzw. zwischen zwei Lichtleitkanälen 16 bildet das Lichtleitermaterial 17 ein Art Lichtleiterbrücken 20, die in etwa die Breite B entsprechend der Trennwände T aufweisen. Es ist erkennbar, dass ein Lichtleitermaterial 17 voll durchgängig oben am Bedienteil 11 verläuft. Diese Schicht Lichtleitermaterial weist über den Trennwänden T die Höhe H auf, welche etwa 30% der Breite B der Lichtleiterbrücken 20 bzw. der Trennwände T betragen kann und etwas über 10% der Höhe der Lichtleitkanäle 16.

Auf einer Oberseite 22 des Lichtleitermaterials 17 mit der durchgehenden Schicht ist hier eine durchgehende Beschichtung 24 vorgesehen, was aber nicht sein muss. Diese Beschichtung 24 besteht aus lichtundurchlässigem Material und ist beispielsweise ein Lack oder eine dünne Materialbeschichtung aus lichtundurchlässigem Kunststoff. In der Beschichtung 24 sind gemäß Fig. 1 drei Symbole 26a bis 26c ausgeschnitten bzw. hier ist die Beschichtung 24 entfernt. Somit kann eine Leuchtanzeige mit der Form bzw. der Leuchterscheinung der Symbole 26a bis 26c geschaffen werden. Die Öffnungen in der Beschichtung 24 bzw. die Symbole 26a bis 26c können herstellungsseitig bei Herstellung des Bedienteils 11 erzeugt werden, alternativ aus einer durchgängigen Beschichtung 24 heraus auch montageseitig.

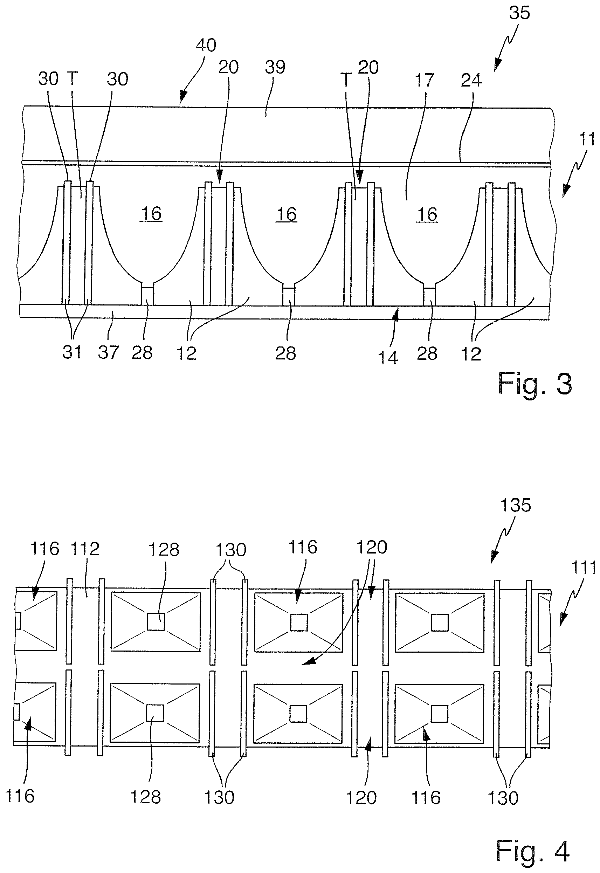

Für die Bedienelementfunktionen sind Teil-Sensorelemente 30a bis 30c vorgesehen. Diese sind als schmale und längliche Streifen ausgebildet aus elektrisch leitfähigem Kunststoff. Diese Streifen sind an der Oberseite des Bedienteilgehäuses 12 bzw. auf den Trennwänden T vorgesehen, wie dies in abgewandelter Form aus der Fig. 4 ersichtlich ist. Entsprechend Fig. 1 weist jeder Lichtleitkanal 16 an seiner linken und seiner rechten Seite jeweils ein solches Teil-Sensorelement 30 auf. Diese sind zwar hier am Bedienteil 11 selbst getrennt voneinander sowie natürlich getrennt von den Teil-Sensorelementen benachbarter Lichtleitkanäle 16. Eine elektrische Kontaktierung erfolgt über die nach unten gezogenen Kontaktabschnitte 31a bis 31c, die über eine Unterseite 14 des Bedienteilgehäuses 12 mit Kontaktvorsprüngen 32a bis 32c überstehen. Damit können sie, wie anhand Fig. 3 vorstellbar ist, auf Kontaktflächen einer Leiterplatte aufgedrückt werden zur elektrischen Kontaktierung. So können dann auch zu einem Lichtleitkanal 16 gehörende Teil-Sensorelemente 30 elektrisch zusammengeschaltet werden.

Aus der Seitenansicht der Fig. 2 ist zu ersehen, dass die Teil-Sensorelemente 30a bis 30c und die Kontaktabschnitte 31a bis 31c streifenartig bzw. kanalartig oder als Erhebungen oder Rippen ausgebildet sind, wie dies beispielsweise in der vorgenannten DE 102012010321.2 beschrieben ist. Somit sind die Trennwände T quasi durchgängig ausgebildet und tragen an der Oberseite die Teil-Sensorelemente 30. Insbesondere können diese angespritzt werden durch Mehrkomponenten-Kunststoffspritzgießen.

Alternativ kann ein Schichtaufbau vorgesehen sein für die Sensorelemente. Dann wären die in Fig. 2 in der Seitenansicht sichtbaren Teile über die Tiefe des Bedienteils 11 in die Zeichenebene hinein durchgehende Schichten. Es würden sich also Schichten des Bedienteilgehäusematerials und des Sensormaterials abwechseln.

In der Fig. 2 ist dargestellt, wie mittels LED 28 unten an den Lichtleitkanälen 16 für den mittleren Lichtleitkanal 16 gemäß Fig. 1 eine Lichtverteilung bzw. Durchleuchtung erfolgt. Das von der LED 28 ausgestrahlte Licht geht entweder direkt nach oben durch die Oberseite 22 des Lichtleitermaterials 17 und, dort wo eine Öffnung in der lichtundurchlässigen Beschichtung 24 als Symbol 26 vorhanden ist, durch dieses hindurch als von oben erkennbare, entsprechend geformte Leuchtanzeige. Alternativ kann ohne eine solche Beschichtung 24 eine großflächige, mindestens der Oberseite des Lichtleitkanals 16 entsprechende Leuchtanzeige geschaffen werden. Es ist auch zu erkennen, wie im Bereich der Lichtleiterbrücke 20 Licht nach oben abgestrahlt wird, welches evtl. durch Mehrfachreflexion an der Spiegel-Beschichtung 18 noch nach außen gespiegelt wird. Somit kann auch im Bereich der Trennwände T bzw. der Lichtleiterbrücken 20 von oben eine Leuchterscheinung gesehen bzw. wahrgenommen werden. Aus der Fig. 2 ist auch zu ersehen, dass hier die Werte für die Lichtdurchlässigkeit, die Breite B und die Höhe H der Lichtleiterbrücke 20, so gewählt sind, dass die Leuchterscheinung nach oben eigentlich ungefähr dort aufhört, wo der benachbarte Lichtleitkanal 16 beginnt. Der Hauptvorteil der Erfindung wird also eigentlich sogar ohne die Beschichtung 24 mit Symbolen darin erreicht. Vorteilhaft kann aber mit einem durchgängig gleich ausgebildeten Bedienteil sowohl partiell eine über mehrere Lichtleitkanäle durchgehende Leuchtanzeige geschaffen werden als auch an einem Ende davon beleuchtete Einzelsymbole.

In der Fig. 3 ist eine erfindungsgemäße Bedieneinrichtung 35 dargestellt ohne durchgängige Beschichtung an der Oberseite. Sie weist ein erfindungsgemäßes Bedienteil 11 auf, das auf einer Leiterplatte 37 aufgesetzt ist. Auf dieser Leiterplatte 37 sind auch die LED 28 angebracht und elektrisch kontaktiert. Oberhalb des Bedienteils 11 verläuft eine Bedienfläche 39, welche durch eine lichtdurchlässige Abdeckung bzw. Platte gebildet wird, beispielsweise eine Gehäusewand eines Elektrogeräts oder eine Kochfeldplatte aus Glaskeramik odgl. eines Kochfeldes. Durch sie hindurch können die Leuchtanzeigen des Bedienteils 11 bzw. die Beleuchtung durch die LED 28 erkannt werden, evtl. auch die beleuchteten Symbole 26a bis 26c. Des Weiteren kann auf eine Oberseite 40 der Bedienfläche 39 ein Finger aufgelegt werden als Betätigung der kapazitiven Sensorelemente bzw. Teil-Sensorelemente 30a bis 30c, wie dies aus dem vorgenannten Stand der Technik bekannt ist.

Leuchten bei der Bedieneinrichtung 35 gemäß der Fig. 3 alle LED 28, so ergibt sich eine durchgehende Lichterscheinung, auch über die Trennwände T mit den Lichtleiterbrücken 20 hinweg. Damit kann beispielsweise eine Art durchgängig beleuchteter Slider geschaffen werden. Eine Beleuchtung kann einer Fingerbewegung folgen und dann wegen des Überleuchtens der Lichtleitkanäle nicht abrupt und sozusagen über eine Lücke von Lichtleitkanal zu Lichtleitkanal springen, sondern als kontinuierliche Beleuchtung dargestellt werden.

In der Fig. 4 ist eine alternative Bedieneinrichtung 135 in Draufsicht skizziert, bei welcher zwei Reihen von Lichtleitkanälen 116 in einem Bedienteil 111 bzw. einem Bedienteilgehäuse 112 vorgesehen sind. Die Lichtleitkanäle 116 sind alle gleich groß bzw. identisch ausgebildet. Das Bedienteilgehäuse 112 bzw. sein lichtundurchlässiges Material trennt benachbarte Lichtleitkanäle 116 sowohl in Längsrichtung des Bedienteils 111 als auch in Richtung quer dazu. Somit sind die Trennwände T entsprechend vorgesehen. Oberhalb der Trennwände T sind Lichtleiterbrücken 120 aus lichtdurchlässigem Lichtleitermaterial vorgesehen, so dass das Überleuchten zwischen benachbarten Lichtleitkanälen 116 in beiden Richtungen längs und quer erfolgen kann. Abhängig von der Ausgestaltung der kapazitiven Sensorelement bzw. Teil-Sensorelemente kann als Abwandlung der Bedieneinrichtung 135 gemäß Fig. 4 ein Bedienteil 111 auch noch mehr Reihen von Lichtleitkanälen und somit Leuchtfeldern aufweisen.

## Patentansprüche

1. Bedienteil für eine Bedieneinrichtung für ein Elektrogerät, wobei das Bedienteil ein Bedienteilgehäuse und mehrere Lichtleitkanäle für Leuchtanzeigen aufweist, wobei die Lichtleitkanäle mit einer sich nach oben bzw. zur Oberseite des Bedienteilgehäuses (13) hin erweiternden Form ausgebildet sind, wobei Leuchtmittel bzw. Lichtquellen (28) unterhalb der Lichtleitkanäle bzw. an deren unterem Endbereich angeordnet sind, wobei die Leuchtanzeigen benachbart und durch Trennwände des Bedienteilgehäuses voneinander getrennt am Bedienteil angeordnet sind, wobei das Bedienteil bzw. das Bedienteilgehäuse zumindest an einer Oberseite der Lichtleitkanäle lichtdurchlässiges Lichtleitermaterial aufweist, wobei das Lichtleitermaterial über mindestens zwei benachbarten Lichtleitkanälen angeordnet ist und durchgehend über diesen zwei benachbarten Lichtleitkanälen verläuft
**dadurch gekennzeichnet, dass** für die Bedienfunktionen kapazitive Sensorelemente (30) vorgesehen sind, die als schmale längliche Teil-Sensorelemente an einer Oberseite bzw. den oberen Bereichen der Trennwände verlaufen, wobei die Teil-Sensorelemente mit einer Breite ausgebildet sind, die der Breite des Lichtleitkanals entspricht.

2. Bedienteil nach Anspruch 1, wobei das Lichtleitermaterial durchgehend über die Trennwand hinweg über diesen zwei benachbarten Lichtleitkanälen verläuft.

3. Bedienteil nach Anspruch 1 oder 2, wobei die Höhe des Lichtleitermaterials über den Trennwänden zwischen 5% und 30% der Höhe der Lichtleitkanäle liegt.

4. Bedienteil nach einem der vorhergehenden Ansprüche, wobei eine Oberseite des Lichtleitermaterials eben ist.

5. Bedienteil nach einem der vorhergehenden Ansprüche, wobei die Lichtleitkanäle von oben her 50% bis zu 95% mit Lichtleitermaterial gefüllt sind.

6. Bedienteil nach einem der vorhergehenden Ansprüche, wobei dass die Oberseite des Lichtleitermaterials bzw. der Lichtleitkanäle mit einer Abdeckung versehen ist, wobei die Abdeckung Öffnungen bzw. Durchlässe in Zeichen- oder Symbolform für die Leuchtanzeigen aufweist.

7. Bedienteil nach Anspruch 6, wobei mindestens eine Leuchtanzeige ein zusammenhängendes bzw. zusammengehörendes Symbol anzeigt, welches über mindestens zwei benachbarten Lichtleitkanälen verläuft.

8. Bedienteil nach einem der vorhergehenden Ansprüche, wobei mehrere Lichtleitkanäle in einer geraden Reihe angeordnet sind.

9. Bedienteil nach einem der vorhergehenden Ansprüche, wobei die Lichtleitkanäle in ein gemeinsames Größenraster passen mit einer Größe oder ganzzahligen Vielfachen dieser zusammengesetzten Größe.

10. Bedienteil nach einem der vorhergehenden Ansprüche, wobei pro Lichtleitkanal ein kapazitives Sensorelement vorgesehen ist, wobei ein Lichtleitkanal zumindest an zwei Seiten von einem kapazitiven Sensorelement umgeben ist.

11. Bedienteil nach einem der vorhergehenden Ansprüche, wobei im oberen Bereich bzw. an der Oberseite der Trennwand parallel zueinander und mit Abstand zueinander zwei Teil-Sensorelemente verlaufen, die jeweils zu dem nach außen benachbarten Lichtleitkanal gehören.

12. Bedieneinrichtung für ein Elektrogerät mit einer Bedienfläche, wobei unter der Bedienfläche mindestens ein Bedienteil nach einem der vorhergehenden Ansprüche angeordnet ist.

13. Bedieneinrichtung nach Anspruch 12, wobei das Bedienteil an eine Unterseite der Bedienfläche angelegt ist.

## Claims

1. Control unit for an operating device for an electric appliance, wherein the control unit has a control unit housing and a plurality of light conductor channels for illuminated displays, wherein the light conductor channels are configured in a shape enlarging upwards or towards the upper side of the control unit housing (13), wherein illuminants or light sources (28) are disposed below the light conductor channels or a bottom end portion thereof, wherein the illuminated displays are disposed on the control unit adjacent and separated from each other by partition walls of the control unit housing, wherein the control unit or the control unit housing has translucent light conductor material at least on an upper side of the light conductor channels, wherein the light conductor material is disposed above at least two adjacent light conductor channels and extends continuously above said two adjacent light conductor channels, **characterized in that**
capacitive sensor elements (30) are provided for the control functions, which sensor elements are narrow elongate partial sensor elements extending on an upper side or the upper portions of the partition walls, wherein the partial sensor elements have a width corresponding to the width of the light conductor channel.

2. Control unit according to claim 1, wherein the light conductor material extends continuously across the partition wall above said two adjacent light conductor channels.

3. Control unit according to claim 1 or 2, wherein the height of the light conductor material above the partition walls is between 5% and 30% of the height of the light conductor channels.

4. Control unit according to any of the preceding claims, wherein an upper side of the light conductor material is planar.

5. Control unit according to any of the preceding claims, wherein the light conductor channels are filled with light conductor material from the top side to 50% up to 95%.

6. Control unit according to any of the preceding claims, wherein the upper side of the light conductor material or of the light conductor channels is provided with a cover, wherein the cover has openings or passages in the shape of characters or symbols for the illuminated displays.

7. Control unit according to claim 6, wherein at least one illuminated display displays a contiguous or combined symbol which extends across at least two adjacent light conductor channels.

8. Control unit according to any of the preceding claims, wherein a plurality of light conductor channels are arranged in a straight row.

9. Control unit according to any of the preceding claims, wherein the light conductor channels are matched to a common size pattern having a size or an integer multiple of said composite size.

10. Control unit according to any of the preceding claims, wherein one capacitive sensor element is provided per light conductor channel, wherein a light conductor channel is enclosed by a capacitive sensor element at least on two sides.

11. Control unit according to any of the preceding claims, wherein two partial sensor elements extend in the upper portion or on the upper side of the partition wall in parallel to each other and spaced from each other, each partial sensor element belonging to the respective outward adjacent light conductor channel.

12. Control device for an electric appliance having a control panel, wherein at least one control unit according to any of the preceding claims is arranged underneath the control panel.

13. Control device according to claim 12, wherein the control unit is applied to a bottom side of the control panel.

## Revendications

1. Élément de commande destiné à un dispositif de commande d'un appareil électrique, dans lequel l'élément de commande comporte un boîtier d'élément de commande et une pluralité de canaux de guidage de lumière pour des affichages lumineux, dans lequel les canaux de guidage de lumière sont réalisés de manière à présenter une forme qui s'élargit vers le haut ou vers la face supérieure du boîtier d'élément de commande (13), dans lequel des moyens d'éclairage ou des sources lumineuses (28) sont disposés en-dessous des canaux de guidage de lumière ou sur leur zone d'extrémité inférieure, dans lequel les affichages lumineux sont disposés côte à côte et séparés les uns des autres sur l'élément de commande par des cloisons du boîtier d'élément de commande, dans lequel l'élément de commande ou le boîtier d'élément de commande comporte un matériau de guidage de lumière transmettant la lumière sur au moins une face supérieure des canaux de guidage de lumière, dans lequel le matériau de guidage de lumière est disposé sur au moins deux canaux de guidage de lumière adjacents et s'étend en continu sur lesdits deux canaux de guidage de lumière adjacents,
**caractérisé en ce qu'**il est prévu, pour les fonctions de commande, des éléments capteurs capacitifs (30) qui s'étendent sous la forme d'éléments capteurs partiels allongés étroits sur une face supérieure ou sur les zones supérieures des cloisons, dans lequel les éléments capteurs partiels sont conçus de manière à présenter une largeur correspondant à la largeur du canal de guidage de lumière.

2. Élément de commande selon la revendication 1, dans lequel le matériau de guidage de lumière s'étend en continu au-dessus de la cloison et au-dessus desdits deux canaux de guidage de lumière adjacents.

3. Élément de commande selon la revendication 1 ou 2, dans lequel la hauteur du matériau de guidage de lumière au-dessus des cloisons est comprise entre 5 % et 30 % de la hauteur des canaux de guidage de lumière.

4. Élément de commande selon l'une des revendications précédentes, dans lequel une face supérieure du matériau guidage de lumière est plane.

5. Élément de commande selon l'une des revendications précédentes, dans lequel les canaux de guidage de lumière sont remplis par le haut de 50% à 95% de matériau de guidage de lumière.

6. Élément de commande selon l'une des revendications précédentes, dans lequel la face supérieure du matériau de guidage de lumière ou des canaux de guidage de lumière est munie d'un couvercle, dans lequel le couvercle présente des ouvertures ou des passages sous la forme de signes ou de symboles destinés aux affichages lumineux.

7. Élément de commande selon la revendication 6, dans lequel au moins un affichage lumineux affiche un symbole continu ou connexe qui s'étend sur au moins deux canaux de guidage de lumière adjacents.

8. Élément de commande selon l'une des revendications précédentes, dans lequel plusieurs canaux de guidage de lumière sont disposés en ligne droite.

9. Élément de commande selon l'une des revendications précédentes, dans lequel les canaux de guidage de lumière s'ajustent sur une grille de tailles commune présentant une taille ou des multiples entiers de ladite taille combinée.

10. Élément de commande selon l'une des revendications précédentes, dans lequel il est prévu un élément capteur capacitif par canal de guidage de lumière, dans lequel un canal de guidage de lumière est entouré sur au moins deux côtés par un élément capteur capacitif.

11. Élément de commande selon l'une des revendications précédentes, dans lequel deux éléments capteurs partiels s'étendent parallèlement l'un à l'autre et de manière espacée l'un de l'autre dans la zone supérieure ou sur la face supérieure de la cloison, chacun d'entre eux appartenant au canal de guidage de lumière adjacent vers l'extérieur.

12. Élément de commande destiné à un appareil électrique présentant une surface de commande, dans lequel au moins un élément de commande est disposé en-dessous de la surface de commande selon l'une des revendications précédentes.

13. Élément de commande selon la revendication 12, dans lequel l'élément de commande est placé sur une face inférieure de la surface de commande.
